# EUROPEAN PATENT APPLICATION

(11) **EP 4 840 985 A1**
(43) Date of publication of application: **18.11.2026**
(21) Application number: 26160727.9
(22) Date of filing: 25.02.2026
(51) Int. Cl.: C23C 14/34, C23C 14/35, C23C 14/54, H01J 37/34

(54) **METHOD OF IMPROVING NON-UNIFORMITY OF FERROMAGNETIC FILMS**

(30) Priority: 12.05.2025 GB 202507236
(71) Applicant: SPTS Technologies Limited, NP18 2TA (GB)
(72) Inventor: MONCRIEFF, Ian, Newport, NP18 2TA (GB); HARRISON, Jack, Newport, NP18 2TA (GB); HYNDMAN, Rhonda, Newport, NP18 2TA (GB); WILBY, Tony, Newport, NP18 2TA (GB)
(74) Representative: Wynne-Jones IP Limited

(57) **Abstract**

The invention provides a method and an apparatus for depositing a magnetic film onto a substrate via physical vapour deposition (PVD). The PVD apparatus comprises a ferromagnetic target supported by a backing plate, from which material can be sputtered onto a substrate by using a magnetron assembly. By adjusting the vertical height of the magnetron assembly above the backing plate, the uniformity of the deposited film on the substrate can be improved.

## Description

### Field of the Disclosure

This invention relates to a method of uniformly depositing a magnetic film onto a substrate via PVD. The invention relates also to an associated PVD apparatus for depositing said magnetic film.

### Background of the Disclosure

Direct Current (DC) sputtering can be used to deposit high purity thin films of pure metals, metal alloys and even dielectric films for the fabrication of semiconductor devices, particularly optoelectronic devices. To deposit the thin films, a negative DC potential is applied to a target in a vacuum system with an inert gas such as Argon (Ar) at a reduced pressure and with a sufficiently high DC voltage to initiate and sustain a stable plasma comprised of inert gas ions, such as Ar⁺ ions. These Ar⁺ ions are attracted to the target which in turn "sputter" target material towards a substrate. In industrial applications, high power magnets are placed in proximity to the target to trap electrons near the target, which in turn provides enhanced ionization, thereby resulting in increased deposition rates due to the higher density of Ar⁺ ions striking the target. The array of magnets close to the target are commonly referred to as a magnetron assembly. Magnetrons can be static or can be scanned over a target, depending on the design of the deposition system.

Conventional DC sputtering systems with magnetrons rely on the magnetic field from the magnets, typically permanent magnets, to achieve very high localized fields. These localized fields penetrate the vacuum chamber in the vicinity of the target face being sputtered. When ferromagnetic targets such as Ni, Fe, FeNi, CoCr etc. are used, there is a significant reduction in magnetic fields produced in the vacuum chamber by the magnetron due to the magnetic field being shunted through the target. Typically, the magnets are spaced as close as possible to a backing plate in the chamber to maximize the magnetic field in the vicinity of the target. If the magnets are static they could be touching the backing plate. However with a rotating/scanning magnetron, a gap is required to facilitate movement of the magnets.

In industrial settings where deposition rate is an important consideration, conventional magnetron assemblies typically operate with thin ferromagnetic targets of ~ 3 mm. Various attempts have been made to reduce shunting of the magnetic field.

Due to target thickness, the PVD chamber needs to be vented before a target change can take place. Once the target is changed, a target conditioning cycle is carried out before the chamber can return to production (i.e. continued sputter deposition). This processes increases down-time of the system and as a consequence increases the overall "Cost of Ownership" (COO) of the system (i.e. the costs associated with operation and production over the lifecycle of a product/process).

US6472867 discloses that 3 mm is a practical limit for Ni targets and further suggests improvements can be made in target lifetime by using a Ni target with a specific texture, namely with an increase of 20% in the crystallographic <200> plane of Ni.

US2011/0186421 discloses the use of a target with slots to allow the magnetic field to penetrate into the vacuum chamber in regions of the target.

Caillard et al., ("Energy Transferred From a Hot Nickel Target During Magnetron Sputtering" IEEE Transactions on Plasma Science, Volume: 42, Issue: 10, October 2014, pages 2802-2803) discloses the use of a heated target to permit improved magnetic field penetration and reduce shunting.

A magnetron of sufficient strength can be provided to allow the sputtering of magnetic materials from standard thickness targets (e.g. 7 mm). However, as magnetic field is shunted through the ferromagnetic target, the target begins to erode, such that two issues occur:
1. the uniformity of the deposited film worsens as the magnetic field from the magnetron becomes concentrated at a major erosion zone; and
2. the maximum B-field becomes pinned at a major erosion zone position.

In DC magnetron sputtering systems with non-ferromagnetic targets, small changes in film uniformity can be accommodated by adjusting the "off-set" of the magnetron assembly; this moves the magnetron axis of rotation in the horizontal X-Y plane - i.e. parallel to the back of the target. With a ferromagnetic target, as the magnetic field gradually increases in the erosion zone through target life, conventional off-set movement in the X-Y plane cannot maintain thickness uniformity through target life. This results in the need to remove the target to maintain uniformity. Thus, when the B-field is pinned at a major erosion zone for a ferromagnetic target, it is not possible to use a magnetron off-set position to correct uniformity through target life.

CN115418617A discloses improving the uniformity and film deposition rate of a deposited magnetic film by employing an elastic adjustment mechanism to a magnetron structure such that the height of the magnetron structure is increased during loss of the target by sputtering, thereby maintaining the distance between the bottom surface of the magnetic target and the magnetron unchanged so that the magnetic field strength and distribution is unchanged.

Accordingly, what is required is an improved magnetron assembly and method of using the assembly to accommodate relatively thick ferromagnetic targets to maintain uniformity, extend target life and in turn significantly improve the availability of the chamber, while also reducing Cost of Ownership of the system.

### Statement of Invention

The present invention, in at least some of its embodiments, addresses the above described problems and needs.

According to a first aspect of the invention, there is provided a method of depositing a magnetic film onto a plurality of substrates comprising:
providing a PVD apparatus comprising:
   - a chamber,
   - a ferromagnetic target supported by a backing plate,
   - a substrate support positioned in the chamber,
   - and a rotating magnetron assembly comprising one or more magnets producing a magnetic field, wherein the magnetron assembly is held at a first height vertically above the backing plate;
repeatedly disposing a substrate on the substrate support and performing a PVD process to deposit a film onto the substrate by sputtering the ferromagnetic target thereby causing erosion of the ferromagnetic target to occur; and
adjusting the vertical height of the magnetron assembly above the backing plate to a second height so as to compensate for a non-uniformity in the deposited film caused by the erosion of the ferromagnetic target;
wherein the second height is greater than the first height.

Thus, to address the problems discussed above, the present inventors have employed an adjustable means in a PVD chamber, which varies the Z-height of the magnetron assembly.

The Z-height refers to the change in the vertical distance of the magnetron assembly above the backing plate on which the target is supported.

Without wishing to be bound by any particular theory or conjecture, it is believed that helps to reduce and spread the magnetic field, and thus 'decouple' it from the target. This Z-height adjustment after erosion allows for maintenance of uniformity of the deposited film throughout the entire target life.

Prior to adjusting the magnetron assembly to the second height, the magnetron can be off-set adjusted in the X-Y plane (i.e. laterally adjusted). The off-set adjustment can be from 0 mm to 10 mm, or from 1 to 10 mm, or from 2 to 8 mm. The off-set adjustment can be achieved by releasing locking pins and moving the adjustable plate on which the magnetron assembly is held, relative to a stationary plate either manually or by actuation and then engaging the locking pins. This lateral adjustment X-Y adjustment helps to broaden the erosion grooves.

The lateral adjustment process allows for continued sputter deposition of a film onto a number of substrates while maintaining film uniformity. As the target is eroded the zone(s) which contribute most to the deposition process produce the deepest erosion zones. Ultimately the principle erosion zone will limit the lifetime of the target. By promoting a wider erosion zone target lifetime of the target can be enhanced as the volume of material from the target is increased. When lateral adjustment can no longer maintain acceptable film properties (i.e. a threshold uniformity), Z-height adjustment can be carried out. Thus, a lateral offset adjustment can be carried out prior to the Z-height adjustment.

A further step can be provided before adjusting the vertical height of the magnetron assembly which comprises measuring the non-uniformity of the deposited films, such that when the non-uniformity is above a threshold value, the vertical height of the magnetron assembly is adjusted to the second height. This non-uniformity threshold value can be referred to as the Upper Specification Limit (USL). The measurement of the non-uniformity can be made outside of the PVD apparatus, although in principle it is possible to make *in situ* measurements of the non-uniformity inside the PVD apparatus.

The USL refers to a quality control parameter which defines the highest allowable value for a specific characteristic, which in this case is the non-uniformity of a deposited film. A person skilled in the art will be familiar with what the USL should be for a given magnetic film. Typically, the non-uniformity can be measured by taking sheet resistance measurements of the film. For example, for Ni magnetic films, the threshold value in terms of sheet resistance is 3%1σ. The sheet resistance can be measured by the well-known "four point probe method". Other methods can be used for measuring the non-uniformity of a deposited film, including MetaPulse (RTM) or X-ray techniques.

Alternatively, the vertical height of the magnetron assembly can be adjusted without reference to a measurement of the non-uniformity of the deposited films. In this case, the vertical height of the magnetron assembly can be adjusted in accordance with a pre-defined algorithm or schedule which can be established based on the known behaviour of the relevant ferromagnetic targets in the apparatus under the relevant operating conditions.

The vertical height of the magnetron assembly can be adjusted by stepping from the first height to the second height. The step from the first to the second height can be triggered by a measurement indicating that the non-uniformity is above the threshold value. Alternatively, it might be possible for the vertical height of the magnetron assembly to be continuously or semi-continuously adjusted until utilization of the target is complete. The non-uniformity can be repeatedly measured throughout to ensure the non-uniformity does not exceed the threshold value, or, if it is found that the non-uniformity does exceed the threshold value, the adjustment of the vertical height can be adapted to bring the non-uniformity below the threshold value. Alternatively, the vertical height can be adjusted according to a pre-defined algorithm.

It is noted that adjusting the vertical height of the magnetron assembly from the first height to the second height may be sufficient to maintain an acceptable degree of uniformity over the target life time. However, the inventors also envisage the possibility of one or more further steps of adjusting the vertical height of the magnetron assembly, i.e. the height of the magnetron assembly can be adjusted from the second height to a third height, from the third height to a fourth height etc.

The PVD process can include a power supply for generating a plasma by any suitable means, such as by DC sputtering, pulsed DC sputtering, or RF sputtering. In DC sputtering, a Direct Current (DC) potential is applied to the ferromagnetic target. The plasma may be produced in a gaseous atmosphere which comprises an inert gas, such as Argon. Other Noble gases might be contemplated. The DC power applied to the target can be from 200 W to 8000 W. The DC potential applied to the target can be in the range of 300 V to 1000 V. The power supply is connected to the target and negatively biases the target so that the targets becomes the cathode. Hence, the negatively charged target attracts positive ions (formed from the plasma) and facilitates sputtering of the target.

Thus, the magnetic film can be deposited using continuous DC magnetron sputtering or pulsed DC magnetron sputtering. The DC magnetron assembly can be a balanced magnetron or an unbalanced magnetron.

A negative bias potential can be applied to the substrate support on which the substrate is disposed. An RF signal having an RF power can be applied to the substrate support to negatively bias the substrate support. The RF power can be in the range of 0 to 600 W.

The substrate support can be metallic, and commonly the substrate support is aluminium or stainless steel. Optionally, the substrate support uses an electrostatic chuck (ESC) to improve thermal contact between the metallic support and the substrate.

The substrate support can be electrically isolated from the chamber by a dielectric break structure. The substrate support can comprise one or both of resistive heater elements and fluid cooling conduits.

The substrate support can be configured to support a substrate having a width which is 150 mm or greater. The width of the target can be greater than the width of the substrate. Thus, the target can overlay and extend radially beyond the substrate support.

The substrate support can be coaxial with the target.

The ferromagnetic target can comprise a material selected from Ni, Co, NiF, or CoCr. The ferromagnetic target can have a thickness of from 3 mm to 10 mm. However, it is a significant advantage of the invention that it enables successful utilization of thicker ferromagnetic targets. Accordingly, the ferromagnetic target can have a thickness of 4 mm or greater, or 5 mm or greater, or from 5 mm to 10 mm. The ferromagnetic target can have a thickness of 6 mm or greater.

The substrate may be a semiconductor substrate, such as a semiconductor wafer. The substrate may be a silicon substrate. The substrate may be a wafer having a radius of 200 mm or 300 mm.

The magnetron assembly may comprise an array of permanent magnets. These permanent magnets may be positioned vertically above the backing plate.

The strength of the magnetic field produced by the magnetron assembly at the surface of the target can be from 60 to 150 Gauss. The peak strength of the magnetic field produced by the magnetron assembly (at the surface of the magnets) can be from 400 to 2000 Gauss.

The magnetron assembly can be held on an adjustable support structure. At least one actuator can be configured to adjust the height of the support structure, thereby adjusting the vertical height of the magnetron assembly above the backing plate. The at least one actuator can be indirectly or directly connected to the support structure. The at least one actuator can be held on a fixed structure which is supported by the backing plate. The at least one actuator can be connected to the support structure via a structure containing a motor, said motor being coupled to the magnetron assembly so as to rotate the magnets. Alternatively, the vertical height of the magnetron assembly can be manually adjusted, such as by using a crank system connected to the magnetron assembly.

The magnetron assembly can be rotated. The magnetron assembly can be rotated at a speed of between 60 to 120 RPM.

As discussed herein, the magnetron assembly is vertically adjusted from a first height to a second height (i.e. the "Z-height" vertical adjustment). The first height of the magnetron assembly with respect to the backing plate can greater than 0 mm, or be from 0 to 2 mm. The difference between the second height and the first height can be 2.5 mm or greater, or from 2.5 to 10 mm, or from 5 to 10 mm.

The difference between the second height and the first height can be equal to or greater than the initial thickness of the ferromagnetic target (i.e. before sputtering has occurred). Hence, for a target of 7 mm thickness, the increase in Z-height can be 7 mm or more.

It is likely that all of the target may be eroded. The removal regions are described as erosion zones. The deepest erosion zone will limit target use.

Thus, erosion of the ferromagnetic target can produce one or more erosion zones. A major erosion zone which has the deepest erosion can also be produced upon erosion of the target.

The vertical height of the magnetron assembly can be adjusted to the second height so that the distance between the bottom of the magnetron assembly and the top of a major erosion zone of the target is increased. The vertical height of the magnetron assembly can be adjusted such that the distance between the bottom of the magnetron assembly and the bottom of the target is increased.

The magnetron assembly can be adjusted to the second height at between 10 to 40 %, or 15 to 35 %, or 20 to 40%, or 20 to 30% of the total lifetime of the ferromagnetic target.

For a Nickel target, the magnetron assembly can be adjusted to the second height at 90 to 100 kWHrs of the ferromagnetic target usage, or at approximately 15 to 25 % of the total lifetime of the Ni target.

According to a second aspect of the invention, there is provided a PVD apparatus comprising:
a chamber;
a substrate support positioned in the chamber;
a ferromagnetic target from which material can be sputtered onto a substrate disposed on the substrate support, wherein the ferromagnetic target is supported by a backing plate;
a rotating magnetron assembly comprising one or more magnets producing a magnetic field configured so that when the PVD apparatus is in use, one or more erosion zones are formed on the ferromagnetic target; and
a height adjustment mechanism for adjusting the vertical height of the magnetron assembly above the backing plate from a first height to a second height so as to compensate for a non-uniformity in the deposited film caused by the erosion of the ferromagnetic target;
wherein the second height is greater than the first height.

The PVD apparatus can also comprise a lateral off-set adjustment mechanism of the magnetron assembly in the horizontal (X-Y) plane.

The apparatus can be configured to perform the vertical height adjustment after the lateral adjustment.

The lateral off-set adjustment can be from 0 mm to 10 mm, or from 1 to 10 mm, or from 2 to 8 mm. The off-set adjustment can be achieved by releasing locking pins and moving the adjustable plate on which the magnetron assembly is held, relative to a stationary plate either manually or by actuation and then engaging the locking pins. The lateral adjustment mechanism can be used to ensure uniformity of the film at a certain threshold. When lateral adjustment can no longer maintain acceptable film properties (i.e. this threshold uniformity), a vertical height adjustment may be carried out. In some cases, a first lateral adjustment may be made until the film is no longer in specification. A Z-height adjustment may then be carried out to maintain desired film specification. A further lateral adjustment may then be carried out again until desired film specification can no longer be maintained, at which point further Z-height adjustments can be made to maintain the desired specification. This process can be repeated throughout the target lifetime.

The magnetron assembly can be held on a height adjustable support structure.

The height adjustment mechanism can comprise at least one actuator configured to adjust the height of the magnetron assembly.

The apparatus can further comprise a controller. The controller can be configured to control the height adjustment mechanism of the magnetron assembly. The controller can control the process parameters during PVD deposition. The controller can be configured to control the apparatus to perform the method of the first aspect of the invention.

The ferromagnetic target can have a thickness of greater than 4 mm. The ferromagnetic target can have a thickness of greater than 5 mm.

For the avoidance of doubt, whenever reference is made herein to 'comprising' or 'including' and like terms, the invention is also understood to include more limiting terms such as 'consisting' and 'consisting essentially'.

Whilst the invention has been described above, it extends to any inventive combination of the features set out above, or in the following description, drawings or claims. For the avoidance of doubt, any features disclosed in relation to the first aspect of the invention may be combined with any features disclosed in relation to the second aspect of the invention and *vice versa* as appropriate.

### Brief Description of Figures

The invention may be performed in various ways, and, by way of example only, embodiments thereof will now be described, reference being made to the accompanying drawings in which:
**Figure 1A** shows magnets (103) from a magnetron placed behind a target (102), wherein the target is supported by a backing plate (101). The magnets (103) are positioned at a height Z1 above the backing plate (101). Magnetic field lines (104) interact with the ferromagnetic material and do not contribute to the field within the vacuum chamber unlike field lines (105) which contribute to electron confinement.
**Figure 1B** shows partially erosion of a ferromagnetic target (102), whereby some of the field lines (107) being shunted through the ferromagnetic target (102) emerge into the vacuum chamber within the erosion zone (106) of the target.
**Figure 1C** shows enhanced erosion of a ferromagnetic target (102), wherein the erosion zone (109) is deepened upon exposure to magnetic flux lines (108).
**Figure 2** shows a schematic representation of a PVD chamber with a variable height magnetron assembly according to the invention.
**Figure 3** shows a plot of the target usage (kWHr) against sheet resistance for a Ni target. The cluster of results on the top right of the graph represents typical process tuning attempts at ~94 kWHrs, while the cluster of results in the bottom right of the graph represent the change in non-uniformity after the magnetron Z-height was increased by 9 mm. The dashed line represents the Upper Specification Limit (USL) for non-uniformity in terms of sheet resistance.
**Figure 4** shows a plot of the sheet resistance against off-set in the X-Y plane of the Ni target at 2, 3, 4, and 6 mm, when the magnetron was 0.75 mm above the target backing plate.
**Figure 5** shows a plot of the sheet resistance against off-set in the X-Y plane of the Ni target at 2, 5, and 7 mm, when the magnetron was 11 mm above the target backing plate.
**Figure 6** shows a plot of the tooling factor against target usage (kWHr) for an Ni target, wherein the Z-height of the magnetron is adjusted at 94 kWHrs.
**Figure 7** shows a flow diagram for a process for controlling non-uniformity of deposition through target life.
**Figure 8** shows a magnetron setup according to the current invention, with magnets behind a ferromagnetic target which is supported by a backing plate with an erosion zone on the target, and with the magnets being held at a height of Z1 + Z2. The Figure shows the magnetic field (110) and magnetic field lines which penetrate the target (111).

### Detailed Description

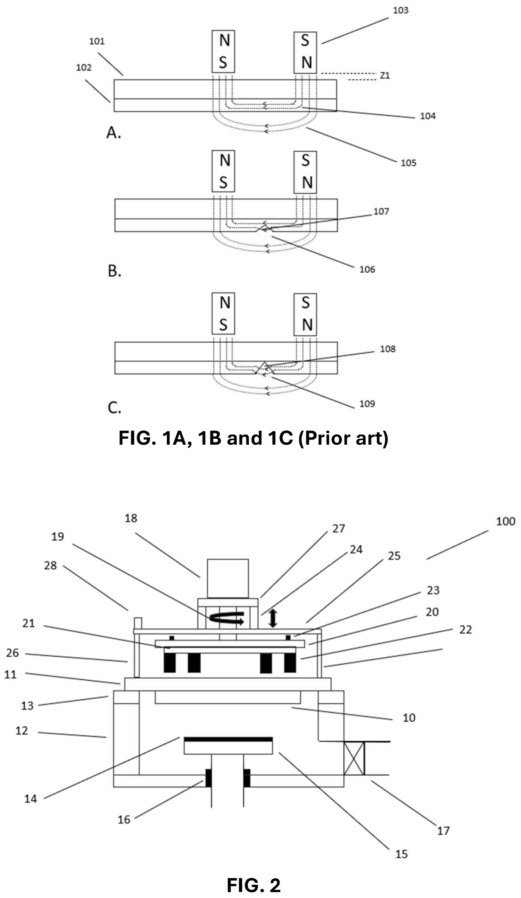

**Figure 1A** shows a conventional, prior art DC sputtering set-up in which the magnets (103) are held positioned at a fixed height Z1 above the backing plate (101). If the magnets were static, Z1 = 0 , such that the magnets touch the backing plate. However, for a rotating magnetron, the Z1 gap/height is > 0.

**Figure 1B** shows a partially eroded ferromagnetic target due to magnetic field (107) being shunted through the ferromagnetic target (102) and emerging into the vacuum chamber within the erosion zone (106) of the target. This produces enhanced ionization in the erosion zone (106) which increases over time as the target is consumed and the erosion zone (106) gets deeper.

The deepening of the erosion zone can be seen in **Figure 1C** , whereby more magnetic flux lines (108) are exposed in the erosion zone (109). This enhanced ionization in the erosion zone (109) can result in a change in thickness uniformity over the substrate. Conventional off-setting techniques used for non-ferromagnetic targets cannot maintain an acceptable uniformity of target thickness for the ferromagnetic DC sputtering set-up shown in **Figures 1A-C**through the entire target life.

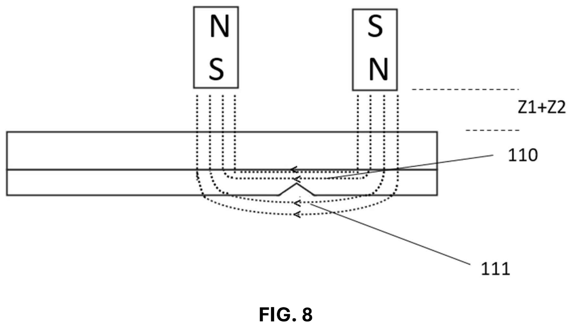

In contrast, in the present invention, by increasing the magnetron to backing plate separation, particularly when magnetron off-set movement can no longer maintain specification (threshold uniformity), more of the magnetic field (110) will be shunted into the remaining target while the magnetic field lines (111) that penetrate the target will be compressed and in turn trap fewer electrons resulting in a lower plasma density and reduced local erosion. This effect is shown in **Figure 8****.**

**Figure 2** shows a schematic representation of a Sigma fxP PVD module (100) as used in the Ni target life enhancement experiments according to the invention. Ferromagnetic target (10) is attached to copper backing plate (11) which is connected to vacuum chamber (12) by vacuum seals in dielectric isolator (13). The vacuum chamber (12) is connected to ground. A substrate (14) is located on wafer support (15) which is isolated electrically from the vacuum chamber (12) by dielectric break (16). The wafer support (15) contains resistive heating and air cooling capabilities and an optional radio frequency bias connection. The wafer support (15) is typically metallic, either aluminium or stainless steel and could also use an ESC (electrostatic chuck) to improve thermal contact between the metallic support and the substrate. The vacuum chamber (12) is pumped through gate valve (17) to the vacuum pumps (not shown). A motor with associated gearbox (18) is coupled through rotating shaft (19) to the magnetron assembly through stationary plate (20) on which adjustable plate (21) is attached. Permanent magnets (22) are positioned above the backing plate (11). With the magnetron, static X-Y adjustment of the position of the adjustment plate can be achieved, and in turn the position of the magnets (22) adjusted, by releasing locking pins (23) and moving adjustable plate (21) relative to stationary plate (20) either manually or by an automated actuator and then engaging locking pins (23). Vertical adjustment of the magnet (22) position with respect to the backing plate (11) is achieved by using actuator (24) which is supported on fixed plate (25) which in turn is supported by a series of rods (26) which are attached to the backing plate (11) or the ceramic break (13). The actuator (24) is connected through top plate (27) to the motor / gearbox (18) assembly. Coolant flow for the backing plate (11) is connected through fittings (28) (only one fitting is shown) to maintain temperature control of the target (10) during sputtering.

Thus, **Figure** 2 shows the layout of the DC sputtering hardware with the variable Z-height magnetron adjustment.

**Table 1 below shows representative, non-limiting ranges of variables at which the process may optionally be carried out.**

| **Parameter** | **Range** |
|---|---|
| Target Material | Ni, Co, NiFe, any ferromagnetic material |
| Target thickness | 3mm - 10mm |
| Magnetron Strength | 400 - 2000 G |
| Target Power | 200W - 8kW |
| Platen RF | 0 - 600W |
| Magnetron Rotation Speed | 60 - 120 RPM |
| Coil current | 0 - 45 A |
| Chamber Pressure | 3 - 20 mT |
| Target Voltage | 340 - 800 V |

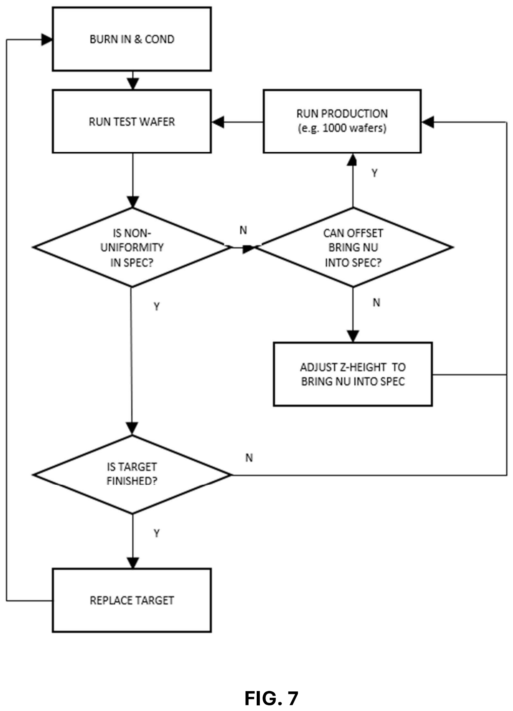

As shown in **Figure 7****,** a method for controlling non-uniformity of film deposition can be employed.

Firstly, the PVD chamber system is vented and the old target replaced with a new thick ferromagnetic target which is "burned in". The chamber is thus conditioned to be ready to return to production.

Test wafer(s) are then run and a proportion of these are measured (for example by looking at the sheet resistance) to ensure the system is operating within the non-uniformity specification (e.g. a USL of 3% for sheet resistance).

If the wafer is not in specification, a conventional X-Y off-set adjustment and measurement is carried out and a defined number of production wafers are run. The number of wafers may be defined by the end user. This cycle is continued until the X-Y off-set no longer brings the non-uniformity into specification.

At this point the Z-height of the magnetron assembly is increased to bring the non-uniformity within specification with the off-set at a minimum value. Production wafers may then commence and when required off-set and Z-height increases may continue until the target is fully utilized. Once utilized, the target can then be replaced.

### Examples

### Non-uniformity testing

Non-uniformity tests were carried out on Ni films using an apparatus/process according to the invention, such as those shown in **Figures 2** **and** **8****.**

Comparative non-uniformity tests were carried out on a conventional magnetron set-up, such as that shown in **Figures 1A-C,**wherein there is no vertical height adjustment.

For ferromagnetic film deposition of all samples, the magnetron has a peak B field of 1400 Gauss which is sufficient to produce the required field of 70 Gauss at the face of a 7mm thick Ni target to produce magnetic confinement of electrons. With the application of DC power this will initiate and sustain a stable plasma at low pressure and voltage so that a high quality Nickel film can be deposited. It is thought that with a magnetic field of >~70 Gauss (or a magnetic field strength sufficient to support ionization of a plasma) at the surface of the thick Ni target that after the initial erosion zone has initiated, potentially at >20% of the total target life, it will be necessary to increase the magnetron separation (i.e. increase the distance of the magnetron from the target by Z2 as shown in **Figure 8** and as according to the invention) to reduce plasma density within the major erosion zone. The point at which the Z height is changed will predominantly depend on the UCL (and not necessarily the total target life) as if it is generally no longer possible to laterally off-set to maintain uniformity, it is at that point at which the Z height will generally need to be increased.

To carry out non-uniformity tests, a measure of sheet resistance against target usage (kWHr) was repeatedly analysed during deposition. In particular, the non-uniformity of the film should not increase beyond the USL for the Ni film, which is 3 %1σ.

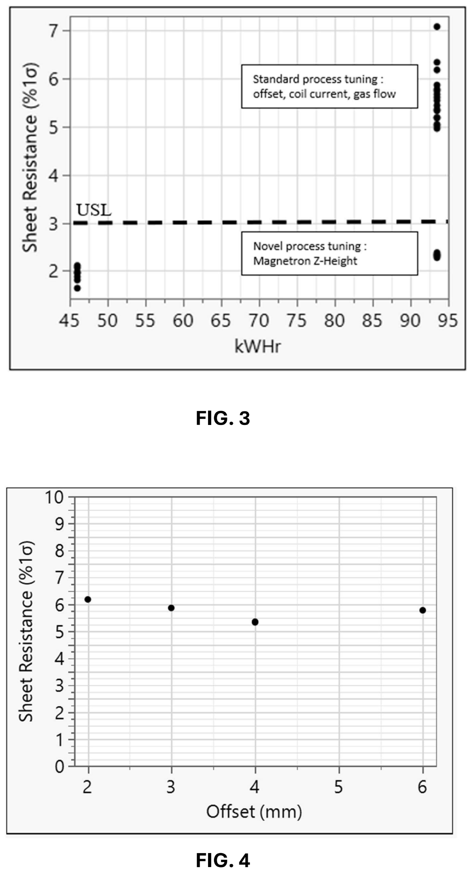

For the comparative example, the magnetron height is maintained at 0.75 mm. Instead of a Z-height adjustment, different tuning effects such as off-setting, manipulation of coil current or gas flow were tried. As a result, the sheet resistance when measured at 94 kWHrs was much greater than the USL (as shown in **Figure 3****).** Thus, these typical tuning techniques did not have the correcting effect that would typically be expected when tuning a non-ferromagnetic material. In fact, when employing an off-set of 2, 3, 4, and 6 mm, the sheet resistance remains above the UCL. Thus, there is no response to non-uniformity using the off-setting technique on the ferromagnetic target (as shown in **Figure 4****).**

In contrast, when the Z-height was increased from a starting position of 0.75 mm by 9 mm at 94 kWHrs, the depth of the major erosion zone was 2.4 mm. The sheet resistance was below 3 %1σ when the Z-height was varied as so (as shown in **Figure 3****).**

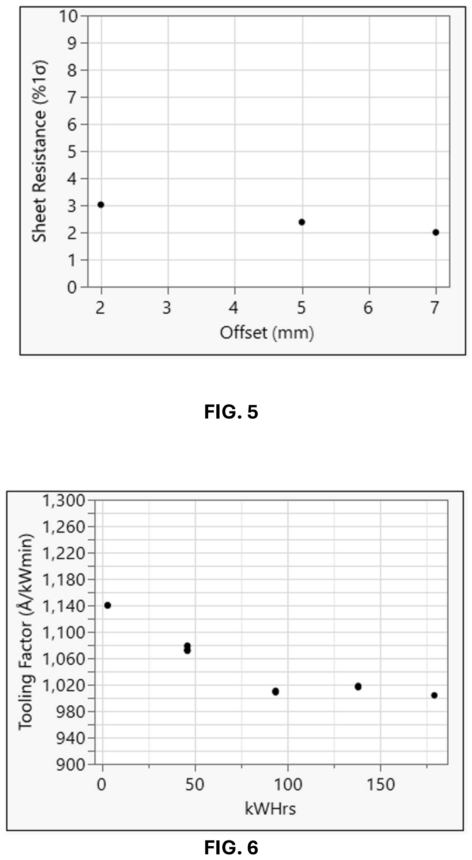

Additionally, the Z-height may be used to control the drop in tooling factor or deposition rate that is normally observed. **Figure 6** also shows the tooling factor vs kWHrs when the Z-height is adjusted at 94 kWHrs. After 94 kWHrs, the tooling factor levels off and changes in this parameter are minimal. This is due to making the magnetic field erode the target surface more efficiently. Tooling factor refers to how the deposition rate changes over time as the target erodes and thus how the power must be adjusted to maintain consistent film thickness. Tooling factor = deposition thickness/power*time, so as the target erodes the deposition rate for a fixed power drops. Thus, to deposit at a consistent thickness, the power can be increased as the target erodes.

A further test was carried out to measure the non-uniformity, wherein both the Z-height was adjusted and off-setting applied. In this case, the magnetron height was increased from 9.75 mm to 11 mm, and the off-set at 2, 5, and 7 mm applied. The results showed that the UCL was below 3 %1 σ. Hence, by varying the Z-height there is a response to non-uniformity (as shown in **Figure 5****).**

**Table 2 shows the results of using the method according to the invention:**

| **Parameter** | **Novel Method** |
|---|---|
| Target Thickness (mm) | 7 |
| Target lifetime (kW.hrs) | 260 |
| Tooling Factor (A/kW.min) | 1050 |
| Wafers per target (50nm film) | 32,000 |

Using the method of the invention, the 7mm thick Ni target could be sputtered with excellent uniformity throughout the target lifetime resulting in 32000 wafers being processed with a 50 nm Ni film. Because a relatively thick ferromagnetic target can be sputtered using the invention, a far higher number of wafers can be processed before the ferromagnetic target needs to be replaced. This results in an enhanced COO.

The skilled reader will appreciate that the invention might be implemented in other ways. For example, the behaviour of a known type of target within a known PVD apparatus under known processing conditions may be sufficiently predictable that it is not necessary to make measurements of the non-uniformity of the deposited films. As can be seen from in the examples above the vertical height of the magnetron assembly was initially adjusted to maintain the desired UCL (see **Figure 3****)** and could be further adjusted even more in conjunction with lateral off-set adjustments (see **Figure 5****).** The target life of the set-up according to the invention was 260 kWhrs and the system was not vented each time a Z-adjustment was made to determine erosion depths. Hence, further Z-height adjustments can be made when X-Y adjustments no longer maintain the desired specification.

## Claims

1. A method of depositing a magnetic film onto a plurality of substrates comprising:
- providing a PVD apparatus comprising:
- a chamber,
- a ferromagnetic target supported by a backing plate,
- a substrate support positioned in the chamber,
- and a rotating magnetron assembly comprising one or more magnets producing a magnetic field, wherein the magnetron assembly is held at a first height vertically above the backing plate;
- repeatedly disposing a substrate on the substrate support and performing a PVD process to deposit a film onto the substrate by sputtering the ferromagnetic target thereby causing erosion of the ferromagnetic target to occur;
- carrying out a lateral off-set adjustment of the magnetron assembly in the horizontal plane; and
- subsequently adjusting the vertical height of the magnetron assembly above the backing plate to a second height so as to compensate for a non-uniformity in the deposited film caused by the erosion of the ferromagnetic target;
wherein the second height is greater than the first height.

2. A method according to claim 1, wherein a further step is provided before adjusting the vertical height of the magnetron assembly which comprises measuring the non-uniformity of the deposited films, such that when the non-uniformity is above a threshold value, the vertical height of the magnetron assembly is adjusted to the second height, optionally wherein the non-uniformity is measured by taking sheet resistance measurements of the deposited films, further optionally wherein the threshold value corresponds to a 3%1σ variance in sheet resistance.

3. A method according to claim 1, wherein the PVD process is DC sputtering.

4. A method according to any preceding claim wherein the ferromagnetic target is comprised of a material selected from Ni, Co, NiFe, or CoCr.

5. A method according to any preceding claim wherein the ferromagnetic target has a thickness of 4 mm or greater, or 5 mm or greater, or from 5 mm to 10 mm.

6. A method according to any preceding claim wherein the ferromagnetic target overlays and extends radially beyond the substrate.

7. A method according to any preceding claim wherein the magnetron assembly is held on a height adjustable support structure.

8. A method according to claim 7, wherein at least one actuator is configured to adjust the height of the support structure, thereby adjusting the vertical height of the magnetron assembly above the backing plate, optionally wherein the at least one actuator is indirectly connected to the support structure, further optionally wherein the at least one actuator is held on a fixed structure which is supported by the backing plate.

9. A method according to claim 8, wherein the at least one actuator is connected to the support structure via a structure containing a motor, said motor being coupled to the magnetron assembly so as to rotate the magnets.

10. A method according to any preceding claim, wherein:
- the strength of the magnetic field produced by the magnetron assembly at the surface of the target is from 60 to 150 Gauss; and/or
- the first height of the magnetron assembly above the backing plate is 0 to 2 mm; and/or
- the difference between the second height and the first height is 2.5 mm or greater, or from 2.5 to 10 mm, or from 5 to 10 mm.

11. A method according to any preceding claim, wherein erosion of the ferromagnetic target produces a major erosion zone, wherein the major erosion zone has the deepest erosion, optionally wherein the vertical height of the magnetron assembly is adjusted to the second height so that the distance between the bottom of the magnetron assembly and the top of a major erosion zone of the target is increased.

12. A PVD apparatus comprising:
a chamber;
a substrate support positioned in the chamber;
a ferromagnetic target from which material can be sputtered onto a substrate disposed on the substrate support, wherein the ferromagnetic target is supported by a backing plate;
a rotating magnetron assembly comprising one or more magnets producing a magnetic field configured so that when the PVD apparatus is in use, one or more erosion zones are formed on the ferromagnetic target;
a lateral adjustment mechanism for off-set adjusting the magnetron assembly in the horizontal plane; and
a height adjustment mechanism for adjusting the vertical height of the magnetron assembly above the backing plate from a first height to a second height so as to compensate for a non-uniformity in the deposited film caused by the erosion of the ferromagnetic target;
wherein the second height is greater than the first height,
and wherein the apparatus is configured to perform the vertical height adjustment after the lateral adjustment.

13. A PVD apparatus according to claim 12, wherein the magnetron assembly is held on a height adjustable support structure, optionally wherein the height adjustment mechanism comprises at least one actuator configured to adjust the height of the magnetron assembly.

14. A PVD apparatus according to claim 13, further comprising a controller which is configured to control the height adjustment mechanism of the magnetron assembly.

15. A PVD apparatus according to any one of claims 13 to 14, wherein the ferromagnetic target has a thickness of greater than 4 mm.
